# EUROPÄISCHE PATENTSCHRIFT

(11) **EP 3 351 072 B1**
(45) Veröffentlichungstag und Bekanntmachung des Hinweises auf die Patenterteilung: **05.06.2019**
(21) Anmeldenummer: 16763833.7
(22) Anmeldetag: 13.09.2016
(51) Int. Cl.: H05K 7/20, H02S 40/34, H05K 7/14

(54) **WECHSELRICHTER ZUR UMWANDLUNG EINER GLEICHSPANNUNG IN EINE WECHSELSPANNUNG**
INVERTER FOR TRANSFORMING DIRECT CURRENT INTO ALTERNATING CURRENT
ONDULEUR DESTINE A LA TRANSFORMATION D'UNE TENSION CONTINUE DANS UNE TENSION ALTERNATIVE

(30) Priorität: 14.09.2015 EP 15185033
(43) Veröffentlichungstag der Anmeldung: 25.07.2018
(73) Patentinhaber: Fronius International GmbH, 4643 Pettenbach (AT)
(72) Erfinder: AITZETMÜLLER, David, 4644 Scharnstein (AT); WINDISCHBAUER, Franz, 4616 Weißkirchen (AT); ARTELSMAIR, Bernhard, 4643 Pettenbach (AT); ACHLEITNER, Günter, 4642 Sattledt (AT); LEITGEB, Ronald, 9361 St. Salvator (AT)
(74) Vertreter: Sonn & Partner Patentanwälte
(86) Internationale Anmeldenummer: PCT/EP2016/071478
(87) Internationale Veröffentlichungsnummer: WO 2017/046041

(56) Entgegenhaltungen:
- EP-A1- 2 675 054
- EP-A2- 2 367 276
- EP-A2- 2 611 273
- US-A1- 2015 138 729

## Beschreibung

Die Erfindung betrifft einen Wechselrichter zur Umwandlung einer Gleichspannung in eine Wechselspannung, insbesondere Photovoltaikwechselrichter für hohe Leistungsdichten, insbesondere Leistungsdichten von 250 W/dm³ bis 500 W/dm³, mit zumindest einem DC-Eingang, einem AC-Ausgang, einem Kühlkörper, einer Leiterplatte, einem DC-Trenner, einem DC-DC-Wandler, einem Zwischenkreis, einem DC-AC-Wandler und einem Gehäuse mit einem Frontdeckel und einer Grundschale.

Aus der EP 2 299 582 A1 ist ein Wechselrichter zur Umwandlung einer Gleichspannung in eine Wechselspannung bekannt. Der Wechselrichter weist ein Gehäuse auf, in dem elektrische Bauteile angeordnet sind. Diese elektrischen Bauteile zur Ausbildung der in einem Wechselrichter notwendigen Komponenten, wie DC-DC-Wandler, Zwischenkreis und DC-AC-Wandler, sind teilweise auf einer Leiterplatte, teilweise in Vertiefungen beiderseits des Kühlluftkanals und teilweise direkt am Kühlkörper, der als Außenwand des Gehäuses ausgebildet ist, angeordnet. Zudem ist an einer weiteren Baueinheit ein DC-Trenner zum sicheren Abtrennen des Wechselrichters von einer Gleichstromquelle, angebracht. Nachteilig ist die relativ aufwändige Herstellung und Wartung dieses Wechselrichters.

Die EP 2 611 273 A2 beschreibt einen Wechselrichter, dessen Komponenten in Bereiche aufgeteilt und so angeordnet werden, dass eine Wandmontage des Wechselrichters unterstützt wird.

Aus der EP 2 367 276 A2 geht ein Wechselrichter hervor, der für die Möglichkeit einer einfacheren Wartung und eine optimale Kühlung der wärmeproduzierenden Bauteile modular in eigenen Bereichen aufgebaut ist.

Der Erfindung liegt somit die Aufgabe zugrunde, ausgehend vom eingangs geschilderten Stand der Technik, den Aufbau eines Wechselrichters zu vereinfachen, wobei zudem eine kompakte Bauweise erreicht werden soll.

Die Erfindung löst die gestellte Aufgabe dadurch, dass die elektrischen Bauteile des DC-DC-Wandlers, Zwischenkreises und DC-AC-Wandlers in Baugruppen zusammengefasst sind, und zumindest der DC-Trenner sowie die Baugruppen des DC-DC-Wandlers, Zwischenkreises und DC-AC-Wandlers direkt auf der Leiterplatte U-förmig korrespondierend mit der Energieflussrichtung vom DC-Eingang zum AC-Ausgang angeordnet sind, und die Leiterplatte mit der Bauteilseite in Richtung Boden der Grundschale des Gehäuses weisend und mit der der Bauteilseite gegenüberliegenden Seite am Kühlkörper angeordnet ist. Durch die Zusammenfassung der elektrischen Bauteile für den DC-DC-Wandler, Zwischenkreis und DC-AC-Wandler in Baugruppen und entsprechende Anordnung direkt auf der Leiterplatte kann der Aufbau des Wechselrichters deutlich vereinfacht und eine kompakte Bauweise erreicht werden. Die Anordnung aller elektrischen Bauteile auf einer Leiterplatte kann nicht nur den einfachen mechanischen Aufbau des Wechselrichters begünstigen, sondern auch dessen Wartbarkeit deutlich erhöhen. So kann im Fehlerfall die gesamte Leiterplatte rasch getauscht werden, wobei nur die Anschlussverbindungen zum DC-Eingang bzw. AC-Ausgang aufgetrennt werden müssen, und die Funktionstüchtigkeit des Wechselrichters innerhalb kürzester Zeit wieder hergestellt werden kann. Eine aufwändige Fehlersuche, welcher Bauteil betroffen ist, kann daher in der installierten Anlage vor Ort vermieden werden. Zudem können aufgrund der U-förmigen Anordnung der Baugruppen von DC-Eingang zu AC-Ausgang die Baugruppen einerseits mittels kurzer Leitungen verbunden werden und anderseits können auch DC-Eingang und AC-Ausgang auf einer Seite, nämlich dem Anschlussbereich, angeordnet sein. Die Anordnung der Leiterplatte mit der Bauteilseite in Richtung Boden der Grundschale des Gehäuses und mit der der Bauteilseite gegenüberliegenden Seite am Kühlkörper erleichtert ebenfalls die Montage und Wartung des Wechselrichters. Die erfindungsgemäße kompakte Bauweise des Wechselrichters ist insbesondere bei Wechselrichtern hoher Leistungsdichten, insbesondere Leistungsdichten von 250 W/dm³ bis 500 W/dm³ von besonderem Vorteil. Dadurch, dass die Leiterplatte mit der der Bauteilseite gegenüberliegenden Seite am Kühlkörper angeordnet ist, kann eine vorteilhafte Kühlung der Leiterplatte und somit der elektrischen Bauteile erreicht werden. Weiters kann der Aufwand für Service und Reparatur vor Ort vereinfacht werden, wenn die Leiterplatte zusammen mit dem Kühlkörper gemeinsam als Austauschelement verfügbar ist.

Im Allgemeinen wird festgehalten, dass abhängig von Baugröße und Einsatz des Wechselrichters auch ein Aufbau mit mehreren DC-Eingängen und DC-DC-Wandlern vorstellbar ist. Auch bei mehrphasigen, insbesondere 3-phasigen Wechselrichtern, mit 3-phasigen AC-Ausgängen kann das erfindungsgemäße Konzept besonders vorteilhaft angewendet werden. Gerade im Zusammenhang mit Solarmodulen kann sich dies als vorteilhaft erweisen, da so die Solarmodule bzw. Stränge von Solarmodulen getrennt in unterschiedlichen Arbeitspunkten betrieben werden können. Diese Arbeitspunkte entsprechen üblicherweise den Maximum Power Points (MPPs) der einzelnen Solarmodule bzw. Strängen von Solarmodulen. Auch eine gleichzeitige oder wechselweise Energieeinspeisung von unterschiedlichen Energiequellen, wie beispielsweise Batterien und Solarmodulen kann durch einen derartigen Aufbau realisiert werden. Ebenso sind mehrere unterschiedliche Ausgänge für den Wechselrichter vorstellbar. So kann beispielsweise ein zusätzlicher Ausgang für Verbraucher mit erhöhter Versorgungssicherheit, die bei geringer Einspeiseleistung an den DC-Eingängen bevorzugt mit Energie versorgt werden, vorgesehen sein.

Wenn die Leiterplatte gegenüber dem Boden der Grundschale des Gehäuses geneigt, vorzugsweise um einen Winkel von maximal 15°, angeordnet ist, können Vorteile bei der Montage und bei der Inbetriebnahme des Wechselrichter resultieren, da durch die Neigung der Leiterplatte auf einer Seite, insbesondere im Anschlussbereich, mehr Platz für die Anschlüsse zum Beispiel der Solarmodule zur Verfügung gestellt werden kann.

Weitere Vorteile können erreicht werden, wenn eine Steuereinheit vorgesehen ist, welche Steuereinheit zentral auf der Leiterplatte angeordnet ist. Die Anordnung der Steuereinheit kann dabei in der Mitte der U-förmigen Anordnung der anderen Baugruppen erfolgen, wodurch kurze Verbindungen zu den anderen Baugruppen resultieren. Falls Solarmodule zur Energieerzeugung und Einspeisung zur Verwendung kommen, kann die Steuereinheit zudem einen oder mehrere optionale MPP (Maximum Power Point)-Tracker ausbilden. Indem die Steuereinheit die Impedanz der DC-DC-Wandler verändert, kann der Arbeitspunkt der Solarmodule eingestellt werden. So kann auch bei einem funktional voll ausgebauten Photovoltaikwechselrichter ein vereinfachter, kompakter Aufbau erreicht werden.

Weist der Wechselrichter zumindest ein EMV-Filter auf, insbesondere ein DC-Eingangs-EMV-Filter und/oder ein AC-Ausgangs-EMV-Filter auf, welches zumindest eine EMV-Filter direkt auf der Leiterplatte angeordnet ist, kann auf vor- bzw. nachgeschaltete EMV-Filter verzichtet werden und können trotzdem die Vorgaben hinsichtlich elektromagnetischer Verträglichkeit erfüllt werden. Zudem werden durch die Anordnung der EMV-Filter direkt auf der Leiterplatte zusätzliche elektrische Komponenten, wie die oben erwähnten vor- bzw. nachgeschalteten EMV-Filter, obsolet, wodurch ein Wechselrichter, dessen gesamten elektrischen Bauteile einschließlich der Steuereinheit auf einer Leiterplatte angeordnet sind, geschaffen wird. Dies bietet Vorteile hinsichtlich Kompaktheit, mechanischem und elektrischem Aufbau sowie Wartung des Wechselrichters.

Begünstigt werden kann die Anordnung der Baugruppen für DC-DC-Wandler, Zwischenkreis und DC-AC-Wandler auf einer Leiterplatte, wenn der DC-DC-Wandler und der DC-AC-Wandler für Schaltfrequenzen über 30 kHz, insbesondere Schaltfrequenzen größer gleich 100 kHz ausgebildet sind. Diese höheren Schaltfrequenzen können durch Minimierung der Verluste, beispielswiese mittels Zero-Voltage-Switching-Topologie bzw. aktiver Schaltentlastung, verwendet werden und erlauben den Einsatz kleinerer Spulen und Drosseln, was deren Montage auf der Leiterplatte vereinfacht und den Aufbau von Wechselrichtern mit hohen Leistungsdichten, insbesondere Leistungsdichten bis 500 W/dm³, begünstigt.

Weiter vereinfacht werden kann der Aufbau des Wechselrichters, wenn im Frontdeckel eine Ausnehmung für ein Betätigungselement des DC-Trenners und ein Lufteinlass angeordnet sind, und eine Betätigungswelle des DC-Trenners, vorzugsweise durch Öffnungen an Leiterplatte und Kühlkörper zum Frontdeckel durchgeführt ist. Zugänglichkeit zum Wechselrichter kann dann nur von der Gehäusefrontseite erforderlich sein, was für unterschiedliche Montagevarianten, wie beispielsweise Wand- oder Deckenmontage, von Vorteil sein kann. Dadurch, dass die Betätigungswelle des DC-Trenners vorzugsweise durch Öffnungen an Leiterplatte und Kühlkörper zum Frontdeckel durchgeführt ist, können das Betätigungselement des DC-Trenners am Frontdeckel und der DC-Trenner in der zweiten, inneren Gehäusekammer direkt auf der Leiterplatte angeordnet sein. Eine Betätigung des DC-Trenners von außen kann so einfach durchgeführt werden, wobei dennoch ein einfacher und kompakter Aufbau des erfindungsgemäßen Wechselrichters erreicht werden kann.

Sind an der Gehäuseschmalseite, insbesondere an allen Gehäuseschmalseiten, zwischen Frontdeckel und Grundschale, insbesondere schlitzförmige, Öffnungen für den Luftauslass vorgesehen, kann die warme Abluft des Wechselrichters gleichmäßig verteilt werden. Gerade bei der Anordnung mehrerer Wechselrichter nebeneinander kann die gleichmäßige seitliche Verteilung der Abluft von Vorteil sein, da sich die nebeneinander befindlichen Wechselrichter nicht über ihren gesamten warmen Abluftstrom gegenseitig erwärmen. Auszeichnen kann sich dies insbesondere bei einer Anordnung des Lufteinlasses im Frontdeckel, da so warme Abluft eines Nachbargeräts nicht bzw. nur kaum angesaugt wird.

Vorzugsweise liegt der Kühlkörper zumindest bereichsweise am Frontdeckel des Gehäuses an, wodurch ein Vibrieren des Frontdeckels durch den angesaugten Kühlluftstrom bzw. von den elektrischen Komponenten oder Lüftermotor verursachten Schwingungen unterbunden werden kann.

Schließt der Kühlkörper zumindest bereichsweise an die Seitenwände der Grundschale des Gehäuses an und der Kühlkörper ein Versteifungsmittel für das Gehäuse gebildet, kann die Stabilität des zusammengebauten Wechselrichters durch den Kühlkörper verbessert werden, was eine einfachere und billigere Gehäusekonstruktion erlaubt. Insbesondere die Grundschale des Gehäuses kann von einer Versteifung durch den Kühlkörper profitieren.

Der Kühlkörper unterteilt das Gehäuse in zumindest zwei Gehäusekammern, wobei zwischen Kühlkörper und Grundschale vorzugsweise eine Dichtung angeordnet ist. Dadurch kann die erste, äußere Gehäusekammer, die Kühlluft von außerhalb des Gehäuses aufnehmen, den Kühlkörper kühlen und die Kühlluft wieder nach außen abgeben. Zudem ist der Kühlkörper in der ersten, äußeren Gehäusekammer durch den Frontdeckel beschattet, was insbesondere bei Montagen des Wechselrichters im Freien von Vorteil sein kann. Die Aufheizung des Innenraums durch solare Einstrahlung kann so wirksam vermindert werden. Die zweite, innere Gehäusekammer hingegen kommt mit der Kühlluft von außerhalb des Gehäuses nicht in Kontakt und kann dementsprechend vor Verunreinigungen sowie Staub geschützt werden. Durch die Anordnung der elektrischen Bauteile in dieser zweiten, inneren Gehäusekammer können die Lebensdauer sowie die Wartungsintervalle des Wechselrichters erhöht werden, da die empfindlichen elektrischen Bauteile vor Verunreinigungen und Staub geschützt sind, was insbesondere durch die vorzugsweise angeordnete Dichtung verbessert wird.

Ist der Längsschnitt der Grundschale des Gehäuses im Wesentlichen trapezförmig ausgebildet, wobei die beiden Seitenwände der Grundschale parallel zueinander sind und eine Seitenwand niedriger als die andere Seitenwand ausgebildet ist, ergibt sich bei der höher ausgebildeten Seitenwand ein höherer Bereich der Grundschale, was eine Verbesserung der Konvektion der Kühlluft und insgesamt eine bessere Kühlung des Wechselrichters bewirkt. Wenn zwischen Kühlkörper und Grundschale eine Dichtung angeordnet ist, kann sich bei einer Grundschale mit trapezförmigem Längsschnitt eine ebene Dichtungskontur ergeben, welche eine einfache und kostengünstige Fertigung der Dichtung erlaubt. Dadurch, dass die Leiterplatte mit ihrer Bauteilseite in Richtung Boden der Grundschale und anschließend an die höhere Seitenwand der Grundschale angeordnet ist, können auch höhere Bauteile im Bereich der höheren Seitenwand platziert werden. Da die höheren Bauteile aufgrund des größeren Volumens auch oft eine größere Wärmeabgabe haben können, kann diese Anordnung im Randbereich zusätzlich zur Kühlung des Wechselrichters beitragen. Gerade wenn der Wechselrichter an der Wand montiert ist, kann nämlich diese höhere Seitenwand oben angeordnet sein. Die damit verbundene Anordnung der wärmeren Bauteilen über den kühleren Bauteilen kann sich auf die Kühlung des Gesamtsystems günstig auswirken. Andererseits werden durch die Anordnung der Leiterplatte mit ihrer Bauteilseite in Richtung Boden der Grundschale die DC-Eingänge und AC-Ausgänge beabstandet vom Boden der Grundschale angeordnet, was den Zugang zu den DC-Eingängen und AC-Ausgängen erleichtern kann. Insbesondere wenn die Leiterplatte parallel zum Kühlkörper verläuft und Grundschale sowie Kühlkörper mit einem trapezförmigen Längsschnitt ausgebildet sind, kann ein Höhensprung im Anschlussbereich erzielt werden. Die Inbetriebnahme bzw. Wartbarkeit des Wechselrichters kann so verbessert werden, wobei dennoch eine Dichtung mit einfacher Dichtkontur ohne Höhensprünge eingesetzt werden kann.

Dies kann nochmals verbessert werden, wenn ein Anschlussbereich zum Anschließen von DC-Quellen an den DC-Eingang und zum Anschließen einer Last oder dgl. an den AC-Ausgang anschließend an die niedrige Seitenwand der Grundschale ausgebildet ist. So kann in diesem Bereich der niedrigen Seitenwand ein einfacherer Zugang zu den Ein- und Ausgängen erreicht werden, da die Seitenwand aufgrund ihrer geringeren Höhe bei Inbetriebnahme und Wartungsarbeiten nicht hinderlich ist.

Innerhalb des Gehäuses können Luftleitelemente angeordnet sein, um den Kühlluftstrom gezielt durch das Gehäuse zu führen. Die Kühlung der Wärme abgebenden Bauteile kann so besonders effektiv erfolgen.

Eine ausreichende elektromagnetische Abschirmung kann erreicht werden, wenn Schirmbleche zum käfigförmigen Umschließen der Leiterplatte einschließlich der darauf angeordneten Baugruppen vorgesehen sind, und vorzugsweise der Kühlkörper bereichsweise einen Teil der Schirmbleche bildet. Der durch die Schirmbleche ausgebildete faradaysche Käfig kann eine besonders effektive Abschirmung von elektromagnetischen Wellen bewirken und das Einhalten vorgegebener EMV-Grenzwerte erlauben. Dadurch, dass der Kühlkörper bereichsweise die Schirmbleche ausbildet, wird der Aufbau der elektromagnetischen Abschirmung vereinfacht. Da der leitfähige Kühlkörper die Aufgabe der Schirmung neben der Kühlung übernehmen kann, kann auf der dem Kühlkörper zugewandten Seite der Leiterplatte diese Doppelfunktion mit nur einem Element, nämlich dem Kühlkörper, gegeben sein.

Die elektromagnetische Abschirmung kann verbessert werden, wenn einzelne Baugruppen, insbesondere EMV-Filter, gegenüber anderen Baugruppen mit Schirmblechen abgeschirmt sind. Eine getrennte Abschirmung von Baugruppen gegenüber anderen Baugruppen, insbesondere den EMV-Filtern, kann ein Aufschaukeln und Übertragen der Abstrahlungen einzelner Baugruppen auf andere Baugruppen verhindern, wodurch für die Abstrahlung erlaubte Grenzwerte eingehalten werden können.

Die Funktionalität des Wechselrichters kann erweitert werden, wenn der Wechselrichter eine Kommunikationseinheit aufweist, welche Kommunikationseinheit direkt auf der Leiterplatte angeordnet ist. Die Kommunikationseinheit kann insbesondere durch eine sogenannte Power-Line-Kommunikationseinheit gebildet sein. Die direkte Anordnung auf der Leiterplatte unterstützt den kompakten Aufbau des Wechselrichters. Je nach Anordnung der Kommunikationseinheit können Informationen mit vor- bzw. nachgeschalteten Komponenten des Energiesystems, wie beispielsweise Batterien, Solarmodulen und bzw. oder Smart-Metern ausgetauscht werden.

Beispielsweise kann bei einem Photovoltaikwechselrichter zur Umwandlung der Gleichspannung von Strängen an Solarmodulen die Kommunikationseinheit zur Kommunikation mit der Modulelektronik an den Solarmodulen ausgebildet sein. Informationen auf Modulebene können so dem Wechselrichter zugänglich gemacht werden. Zudem kann mit einem modulseitig angeordneten Sicherheitselement, einer sogenannten Rapid-Shutdown-Box, kommuniziert werden, um im Fehlerfall die Energiezufuhr direkt bei den Solarmodulen abschalten zu können.

Ist der DC-AC-Wandler und/oder der DC-DC-Wandler für einen bidirektionalen Energiefluss ausgebildet, kann sowohl Energie an den oder die Verbraucher abgegeben werden als auch Energie aufgenommen werden, um vorhandene Energiespeicher, beispielsweise Batterien, aufzuladen. Ein derartiger Wechselrichter kann sowohl Energie in dafür vorgesehenen Energiespeichern speichern als auch entnehmen und kann daher auch für eine temporäre Notstromversorgung eingesetzt werden. Abhängig vom jeweiligen Energiespeicher kann dessen Anschluss an den DC-Eingängen aber auch am Zwischenkreis erfolgen.

Die gegenständliche Erfindung wird nachfolgend unter Bezugnahme auf die beigefügten Zeichnungen, die beispielhaft, schematisch und nicht einschränkend, vorteilhafte Ausgestaltungen der Erfindung zeigen, näher erläutert. Dabei zeigen
- Fig. 1: ein Blockschaltbild eines beispielhaften Wechselrichters;
- Fig. 2: eine Explosionszeichung eines Wechselrichters;
- Fig. 3: eine Draufsicht auf die Leiterplatte des Wechselrichters;
- Fig. 4: eine Seitenansicht auf das Gehäuse des Wechselrichters;
- Fig. 5: einen Längsschnitt durch das Gehäuse des Wechselrichters entlang der Schnittlinie V-V nach Fig. 2; und
- Fig. 6: eine Explosionszeichung von Leiterplatte und umschließenden Schirmblechen des Wechselrichters.

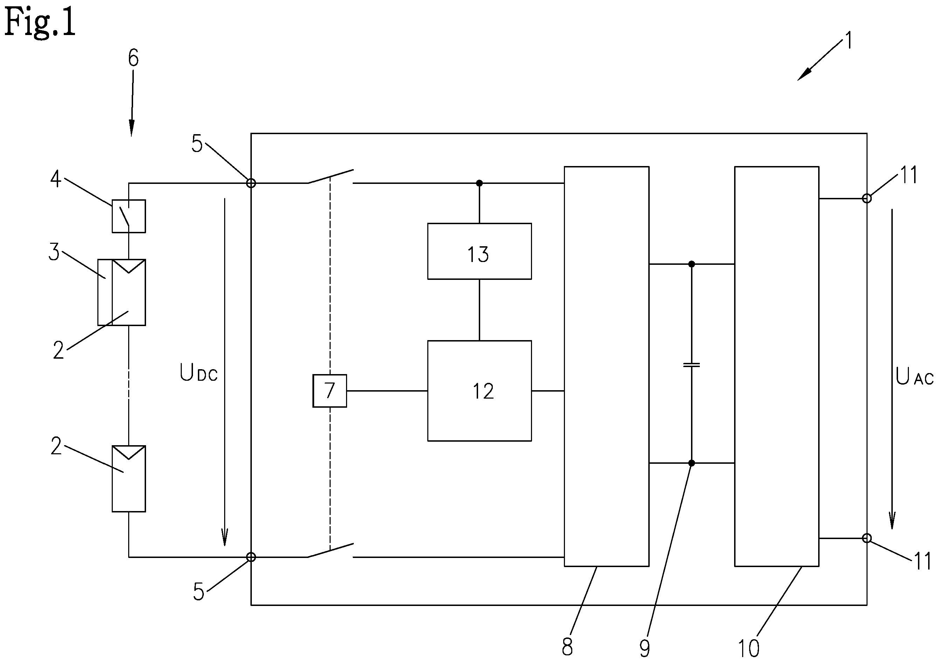

Fig. 1 zeigt das Blockschaltbild eines beispielhaften Wechselrichters 1, insbesondere eines Photovoltaikwechselrichters, der zur Umwandlung einer Gleichspannung U_{DC} in eine Wechselspannung U_{AC} dient. Die Gleichspannung U_{DC} wird bei diesem Ausführungsbeispiel von den Solarmodulen 2 der Photovoltaik-Anlage erzeugt. Dabei sind manche Solarmodule 2 mit einer Modulelektronik 3 ausgerüstet und eine sogenannte Rapid-Shutdown-Box 4 kann nahe den Energie erzeugenden Solarmodulen 2 angeordnet sein. Die Rapid-Shutdown-Box 4 ist eine Sicherheitsvorkehrung für den Fehlerfall, um den Stromfluss auch in der Nähe der Solarmodule 2 unterbrechen zu können. Die Einspeisung der Gleichspannung U_{DC} in den Wechselrichter 1 erfolgt über den DC-Eingang 5. Üblicherweise sind in einer Photovoltaik-Anlage mehrere Solarmodule 2 zu Strängen 6 zusammengeschaltet, wobei mehrere Stränge 6 parallel an einem DC-Eingang 5 geschaltet werden. Der Wechselrichter 1 ist normalerweise mit mehreren DC-Eingängen 5 ausgestattet, wovon der Einfachheit halber im Blockschaltbild nur ein DC-Eingang 5 dargestellt ist. Diesem DC-Eingang 5 bzw. DC-Eingängen nachgeschaltet ist ein DC-Trenner 7 angeordnet, um die Energiezufuhr zum Wechselrichter 1 unterbrechen zu können. Über DC-DC-Wandler 8, Zwischenkreis 9 und DC-AC-Wandler 10 wird die Gleichspannung U_{DC} umgewandelt und die elektrische Leistung in Form einer Wechselspannung U_{AC} an den AC-Ausgang 11 weitergeleitet. Die Umwandlung der Gleichspannung U_{DC} in die Wechselspannung U_{AC} erfolgt unter Kontrolle einer Steuereinheit 12, die mittels nicht näher dargestellten Messwerten und Einstellwerten die aktuellen Betriebsparameter anpasst. Zudem hat die Steuereinheit 12 Zugriff auf eine Kommunikationseinheit 13, beispielsweise eine Power-Line-Kommunikationseinheit, um Daten mit wechselrichterfernen Komponenten, beispielsweise der Modulelektronik 3 von Solarmodulen 2, auszutauschen.

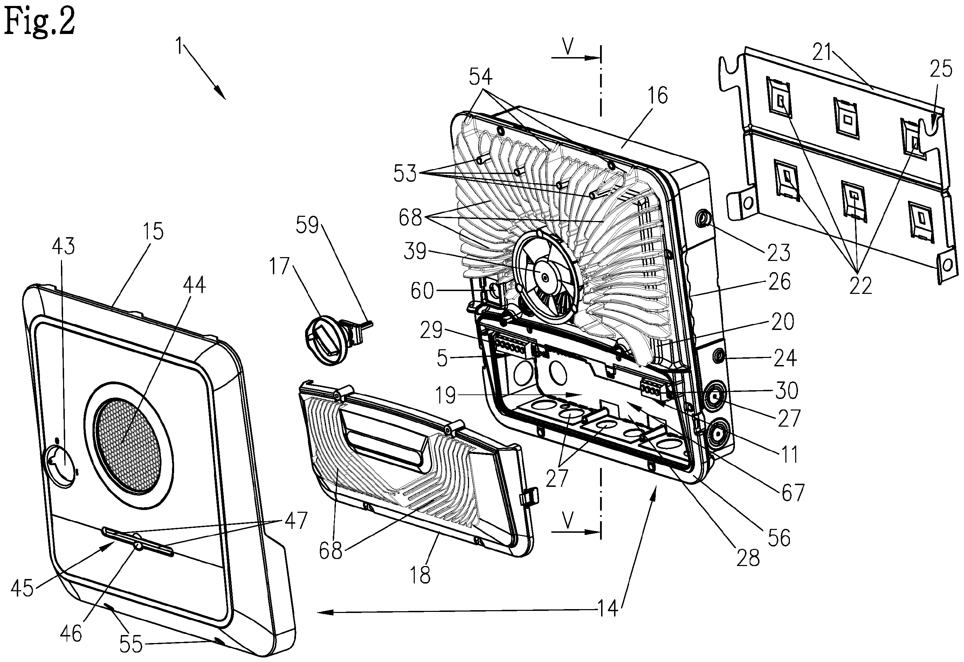

Üblicherweise sind die oben erwähnten Bestandteile des Wechselrichters 1 in einem Gehäuse 14 eingebaut, dessen umschließende Elemente Frontdeckel 15 und Grundschale 16 sind, wie in der Explosionszeichnung einer beispielhaften Ausführung in Fig. 2 dargestellt wird. Diese zeigt von links nach rechts betrachtet aus Frontdeckel 15, Betätigungselement 17 für DC-Trenner 7, Abdeckung 18, Anschlussbereich 19, Kühlkörper 20 montiert auf Grundschale 16 und Wandhalterung 21. Dabei weist die Wandhalterung 21 für deren Befestigung mehrere Löcher 22 auf. Für die Befestigung der Grundschale 16 bzw. des zusammengebauten Wechselrichters 1 an der Wandhalterung 21 sind an der Grundschale 16 beidseitig je zwei Haltepunkte 23, 24 vorhanden. Dabei können die oberen Haltepunkte 23 in die entsprechenden Aufnahmen 25 der Wandhalterung 21 geführt werden und durch eine anschließende Schwenkbewegung kann ein Einschnappen der unteren Haltepunkte 24 in die Wandhalterung 21 bewirkt werden. Zudem bildet die Grundschale 16 beidseitig zwischen den Haltepunkten 23, 24 für die Wandhalterung 21 Griffmulden 26 aus. Dies erlaubt eine leicht handhabbare, werkzeuglose Befestigung des Wechselrichters 1 an der Wandhalterung 21, wobei trotz des Verzichts auf Schraubverbindungen eine stabile Verbindung erreicht wird. Im unteren Teil der Grundschale 16, der nicht durch den Kühlkörper 20 abgedeckt ist, ist der Anschlussbereich 19 erkennbar. In diesem Bereich sind in der Grundschale 16 mehrere ausbrechbare Anschlussöffnungen 27 angeordnet. Des Weiteren ist im Inneren des Anschlussbereichs 19 ein metallischer Einlegeteil 28 erkennbar. Dieser ist beim Anschluss des Wechselrichters 1 mit Erde zu verbinden und stellt für den gesamten Anschlussbereich 19 sodann die Schutzerdung dar. Die Anschlussklemmen 29, 30 des DC-Eingangs 5 und AC-Ausgangs 11 sind im oberen Anschlussbereich 19 zu sehen.

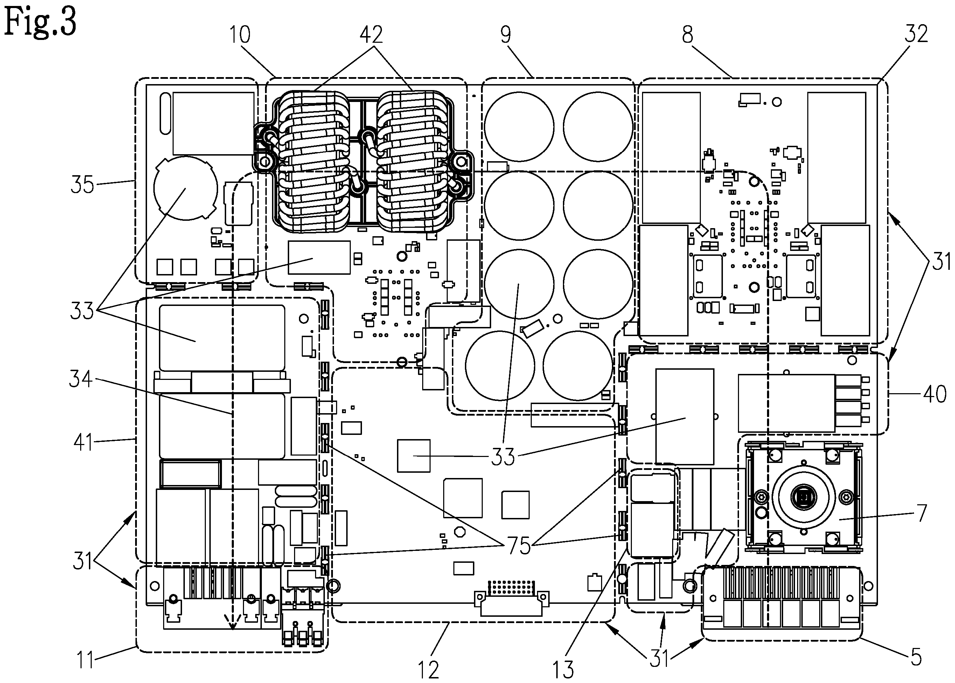

Die Anschlussklemmen 29, 30 sind steckbar ausgeführt und stellen die Verbindung zur Leiterplatte 32 (siehe Fig. 3) her. Diese ist beim dargestellten Wechselrichter 1 in der Grundschale 16 angeordnet. Auf der Leiterplatte 32 sind erfindungsgemäß die elektrischen Bauteile 33 für DC-DC-Wandler 8, Zwischenkreis 9 und DC-AC-Wandler 10 in Baugruppen 31 zusammengefasst. Dabei sind DC-Trenner 7 sowie die Baugruppen 31 für DC-DC-Wandler 8, Zwischenkreis 9 und DC-AC-Wandler 10 direkt auf der Leiterplatte 32 U-förmig korrespondierend mit der Energieflussrichtung 34 von DC-Eingang 5 zu AC-Ausgang 11 angeordnet. Für die Montage des DC-Trenners 7 auf der Leiterplatte 32 kommt dabei eine spezielle Variante eines DC-Trenners 7 mit Lötanschlüssen zum Einsatz. Dementsprechend ist der DC-Trenner 7 in Energieflussrichtung anschließend an den DC-Eingang 5 auf der Leiterplatte 32 montiert. Zusätzlich zu den vorgenannten Baugruppen 31 ist im gezeigten Ausführungsbeispiel zur Überwachung der Summenströme eine sogenannte Residual-Current-Monitoring-Unit 35 auf der Leiterplatte 32 angeordnet. Durch die gemeinsame Anordnung der Bauteile 33 einer Leiterplatte 32 wird der Aufbau des Wechselrichters 1 deutlich vereinfacht. Damit ist einerseits der Fertigungsprozess besser optimierbar, beispielsweise durch Schwalllöten sämtlicher Hochstromverbindungen bei gleichzeitigem Entfall von störanfälligen Kabelverbindungen. Andererseits ergeben sich auch eine verbesserte Wartbarkeit und vereinfachte Reparaturen, da im Fehlerfall die gesamte Leiterplatte 32 getauscht werden kann. Dabei müssen nur die steckbar ausgeführten Anschlussklemmen 29, 30 zum DC-Eingang 5 bzw. AC-Ausgang 11 abgesteckt, die Leiterplatte 32 getauscht und wieder angesteckt werden. Vorteilhaft dabei ist auch die U-förmige Anordnung der Baugruppen 31 von DC-Eingang 5 zu AC-Ausgang 11, da dadurch einerseits nur kurze Verbindungen zwischen den Baugruppen 31 erforderlich sind, anderseits aber auch der DC-Eingang 5 und AC-Ausgang 11 an einem seitlichen Randbereich der Leiterplatte 32, nämlich dem dem Anschlussbereich 19 zugewandten Randbereich, angeordnet sind. Die Funktionstüchtigkeit des Wechselrichters 1 ist so innerhalb kürzester Zeit wieder hergestellt. Eine aufwendige Fehlersuche, welche Baugruppe 31 bzw. Bauteil 33 betroffen ist, braucht daher in der installierten Anlage vor Ort nicht durchgeführt werden.

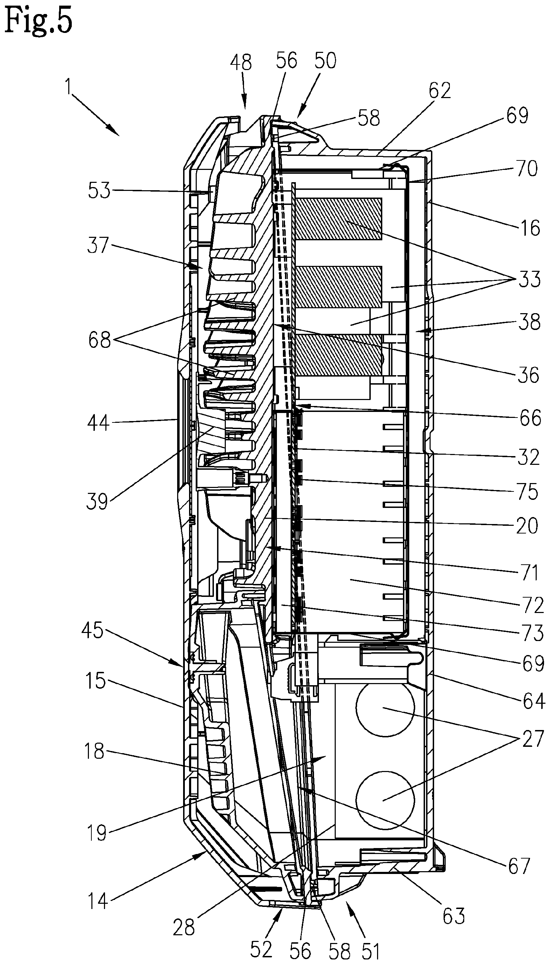

Außerdem ist, wie in Fig. 2 erkennbar, der Kühlkörper 20 mit seiner Haupterstreckungsebene 36 im Wesentlichen parallel zwischen Frontdeckel 15 und Grundschale 16 angeordnet. So unterteilt der Kühlkörper 20 das Gehäuse 14 in zwei Kammern 37, 38 (vgl. Fig. 5) und verbessert gleichzeitig dessen mechanische Stabilität. Der Lüfter 39 ist dabei an Gerätevorderfront zwischen Frontdeckel 15 und Kühlkörper 20 mit Luftrichtung senkrecht auf den Kühlkörper 20 angeordnet. Im gezeigten Ausführungsbeispiel ist der Lüfter 39 zentral am Kühlkörper 20 angebracht, und in einer Ausnehmung des Kühlkörpers 20 versenkt. Allerdings wäre auch der Einsatz eines deutlich größeren Lüfters 39 mit einem Durchmesser bis annähernd der Gehäusebreite denkbar, ohne dabei die Gehäusetiefe maßgeblich zu beeinflussen. Ein einfach aufgebauter und kompakter Wechselrichter 1, der auch für hohe Leistungsdichten von 250 W/dm³ bis zu 500 W/dm³ eingesetzt werden kann, ist so, wie im Ausführungsbeispiel gezeigt, realisierbar.

Aus Fig. 3 ist weiters erkennbar, dass die Steuereinheit 12 des Wechselrichters 1 zentral auf der Leiterplatte 32 angeordnet ist, nämlich in der Mitte der U-förmigen Anordnung der anderen Baugruppen 31. Kurze Verbindungen zu jeder der anderen Baugruppen 31 sind die Folge. Außerdem übernimmt die Steuereinheit 12 die Funktion des MPP-Trackers für die Solarmodule 2. So kann auch bei einem funktional voll ausgebauten Wechselrichter 1 für Solarmodule 2 ein vereinfachter, kompakter Aufbau erreicht werden.

Auch das DC-Eingangs-EMV-Filter 40 und das AC-Ausgangs-EMV-Filter 41 sind direkt auf der Leiterplatte 32 angeordnet. Vor- bzw. nachgeschaltete EMV-Filter werden dadurch obsolet und die Vorgaben hinsichtlich elektromagnetischer Verträglichkeit können dennoch erfüllt werden. So sind am Wechselrichter 1 die gesamten elektrischen Komponenten auf nur einer Leiterplatte 32 angeordnet, was den mechanischen und elektrischen Aufbau vereinfacht und damit auch Handhabbarkeit und Servicefreundlichkeit verbessert. Dabei erfolgt der Anschluss an DC-Eingang 5 und AC-Ausgang 11 über Stecker, um trotz des kompakten Aufbaus einen schnell und einfach handhabbaren Anschluss durchführen zu können. Ein erfindungsgemäßer Wechselrichter 1, dessen gesamten elektrischen Bauteile 33 einschließlich der Steuereinheit auf einer Leiterplatte 32 angeordnet sind, bietet deutliche Vorteile hinsichtlich Kompaktheit, mechanischem und elektrischem Aufbau sowie Wartbarkeit.

Da sowohl DC-DC-Wandler 8 als auch DC-AC-Wandler 10 vorzugsweise für Schaltfrequenzen von 30kHz und darüber ausgebildet sind, wird eine vereinfachte Anordnung der Baugruppen 31 für DC-DC-Wandler 8, Zwischenkreis 9 und DC-AC-Wandler 10 auf nur einer Leiterplatte 32 ermöglicht. Diese höheren Schaltfrequenzen werden durch den Einsatz von Zero Voltage Switching bzw. durch eine aktive Schaltentlastung erreicht. Damit werden die Schaltverluste minimiert, was erst den wirtschaftlichen Einsatz der hohen Schaltfrequenzen erlaubt. Durch eben diese höheren Schaltfrequenzen wird der Einsatz von kleiner dimensionierten Spulen und Drosseln 42 ermöglicht, was die Montage auf der Leiterplatte 32 erleichtert, da eine zusätzliche mechanische Befestigung dieser Bauteile 33 entfallen kann.

Wie aus Fig. 2 zu entnehmen ist, sind im Frontdeckel 15 eine Ausnehmung 43 für ein Betätigungselement 17 des DC-Trenners 7 und ein Lufteinlass 44 angeordnet. Des Weiteren ist unterhalb des Lufteinlasses 44 ein Anzeige- und Bedienelement 45 mit einem kapazitiven Taster 46 und LED's 47 angebracht. Dadurch ist im Betrieb der Zugang zum Wechselrichter 1 nur von der Gehäusefrontseite erforderlich, was den Wechselrichter 1 sowohl für Wandals auch Deckenmontage geeignet macht.

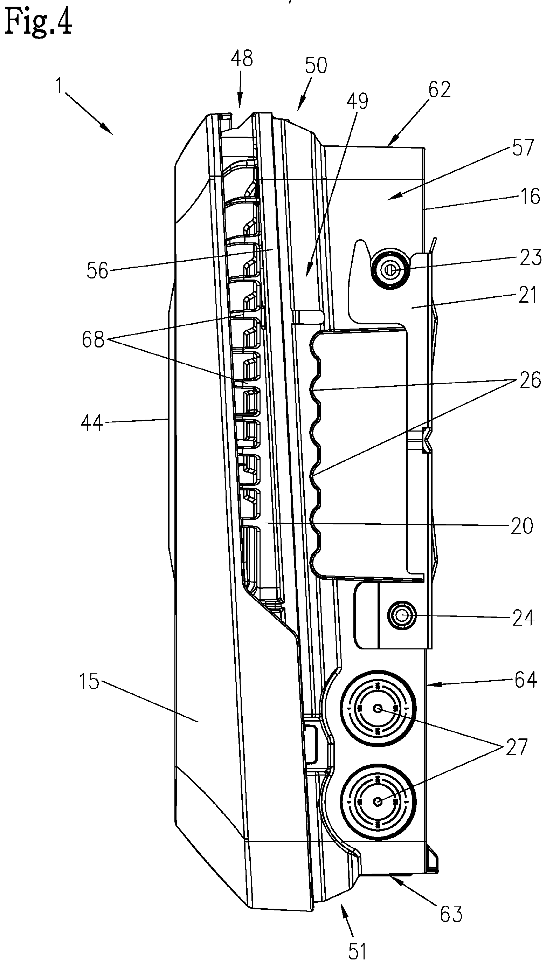

In der Seitenansicht des Wechselrichters 1 in Fig. 4 ist eine schlitzförmige Öffnung 48 zur Bildung eines Luftauslasses an der Gehäuseschmalseite 49 zwischen Frontdeckel 15 und Grundschale 16 erkennbar. Wie ersichtlich, verläuft diese Öffnung 48 auch über die obere Schmalseite 50 und weiter zur der der Gehäuseschmalseite 49 gegenüberliegenden Schmalseite. Vorteilhafterweise ist auch an der unteren Schmalseite 51 eine schlitzförmige Öffnung 52, die im Schnitt in Fig. 5 erkennbar ist. Dementsprechend wird die warme Abluft des Wechselrichters 1 allseitig um das Gehäuse 14 verteilt. Bei einer Anordnung mehrerer Wechselrichter 1 nebeneinander besteht daher nicht die Gefahr, dass die gesamte warme Abluft eines Wechselrichters 1 von benachbart angeordneten Wechselrichtern 1 als "Kühlluft" angesaugt wird, was die Effektivität der Kühlung deutlich verringern würde. Außerdem zeichnet sich in diesem Zusammenhang die Anordnung des Lufteinlasses 44 im Frontdeckel 15 als vorteilhaft aus, da so warme Abluft eines Nachbargeräts nicht bzw. nur kaum angesaugt wird.

Aus dem Längsschnitt in Fig. 5 ist ersichtlich, dass der Kühlkörper 20 bereichsweise am Frontdeckel 15 anliegt. Der Frontdeckel 15 wird dabei über vier Zapfen 53, die in Fig. 2 bzw. Fig. 5 sichtbar sind, abgestützt. Der Frontdeckel 15 hintergreift mit seinem oberen Rand Vorsprünge 54 des Kühlkörpers 20, liegt an den Zapfen 53 an und wird mit Schrauben 55 an seinem unteren Rand am Kühlkörper 20 fixiert. Die daraus resultierende Spannung im Frontdeckel 15 verhindert Vibrationen des Frontdeckels 15, die durch den Betrieb des Wechselrichters 1 bzw. aufgrund des angesaugten Kühlluftstroms verursacht werden könnten.

Außerdem schließt der Kühlkörper 20 mit seinem umlaufenden Rahmen 56 an sämtliche Seitenwände 57, 62, 63 der Grundschale 16 an und bildet eine Versteifung für das Gehäuse 14. Die Stabilität des zusammengebauten Wechselrichtergehäuses 14 wird durch den Kühlkörper 20 verbessert, was eine einfachere und kostengünstigere Konstruktion der Grundschale 16 erlaubt.

Zudem unterteilt der Kühlkörper 20 das Gehäuse 14 in zumindest zwei Gehäusekammern 37, 38. Dabei wird die erste, äußere Gehäusekammer 37 zwischen Frontdeckel 15 und Kühlkörper 20 und die zweite, innere Gehäusekammer 38 zwischen Kühlkörper 20 und Grundschale 16 gebildet. Die Kühlluft von außerhalb des Gehäuses 14 wird daher nur von der ersten, äußeren Gehäusekammer 37 aufgenommen, um den Kühlkörper 20 zu kühlen. Außerdem ist der Kühlkörper 20 durch die erste, äußere Gehäusekammer 37 beschattet, wodurch eine Erwärmung des Kühlkörpers 20 durch direkte Sonneneinstrahlung vermieden wird. Dies ist insbesondere bei Montage des Wechselrichters 1 im Freien von Vorteil. Die zweite, innere Gehäusekammer 38 hingegen kommt mit der Kühlluft von außerhalb des Gehäuses 14 nicht in Kontakt und ist dementsprechend vor Verunreinigungen sowie Staub geschützt. Durch die Anordnung der elektrischen Bauteile 33 in dieser zweiten, inneren Gehäusekammer 38 werden daher Lebensdauer sowie Wartungsintervalle des Wechselrichters 1 erhöht, da verunreinigungsbedingte Fehler verhindert werden.

Mit der Dichtung 58 zwischen Kühlkörper 20 und Grundschale 16 wird die zweite, innere Gehäusekammer 38 abgedichtet und der Schutz der zweiten, inneren Gehäusekammer 38 vor Verunreinigungen und Staub ist dementsprechend verbessert.

Die Betätigungswelle 59 des DC-Trenners 7 ist durch Öffnungen 60 an Leiterplatte 32 und Kühlkörper 20 zur Vorderseite des Gehäuses 14 geführt. Dabei verläuft die Betätigungswelle 59 durch die äußere Gehäusekammer 37. Dies erlaubt die Anordnung des Betätigungselements 17 des DC-Trenners 7 am Frontdeckel 15 einerseits und des DC-Trenners 7 in der zweiten, inneren Gehäusekammer 38 direkt auf der Leiterplatte 32 andererseits. Dazu ist das Zentrum des DC-Trenners 7 fluchtend mit der Öffnung 60 an Leiterplatte 32 und Kühlkörper 20 angeordnet, damit die Betätigungswelle 59 in den DC-Trenner 7 eingreifen kann. Das Betätigungselement 17 ist in einer Ausnehmung am Kühlkörper 20 formschlüssig fixiert, wobei die Betätigungswelle 59 durch die Öffnung 60 ragt und in den DC-Trenner 7 eingreift. Zugleich wird durch diese Fixierung des Betätigungselements 17 die Öffnung 60 abgedichtet, wodurch der Schutz der zweiten, inneren Gehäusekammer 38 vor Verunreinigungen und Staub, trotz durchgeführter Betätigungswelle 17, erhalten bleibt. Der DC-Trenner 7 kann so einfach von außen betätigt werden, wobei dennoch ein einfacher und kompakter Aufbau des erfindungsgemäßen Wechselrichters 1 erreicht wird.

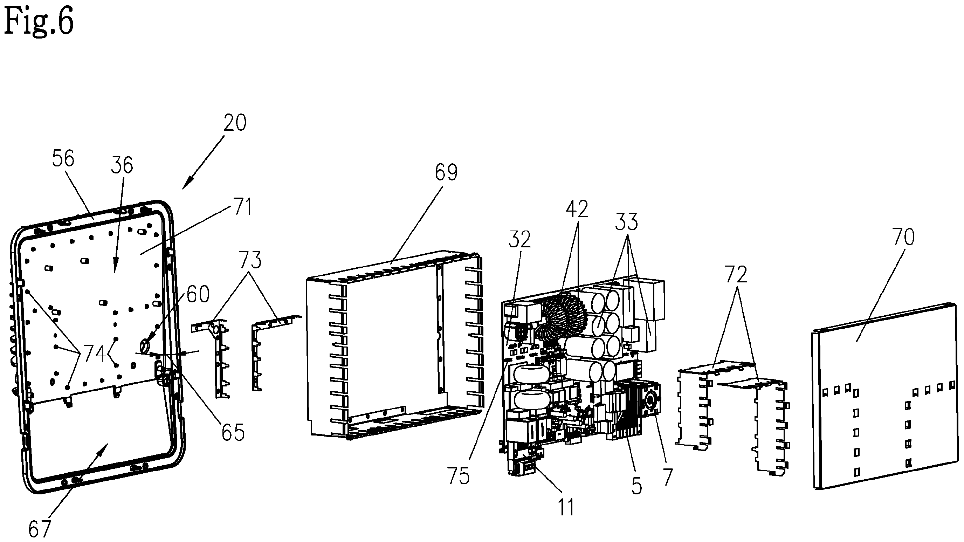

Gemäß Fig. 5 ist der Längsschnitt entlang der Schnittlinie V-V nach Fig. 2 der Grundschale 16 im Wesentlichen trapezförmig, wobei die beiden Seitenwände 62, 63 parallel zueinander sind. Dementsprechend ist die Seitenwand 62 höher als die andere Seitenwand 63 ausgebildet. Da die Haupterstreckungsebene 36 des Kühlkörpers 20 parallel zum Boden 64 der Grundschale 16 liegt, ist der umlaufende Rahmen 56 des Kühlkörpers 20 zur Haupterstreckungsebene 36 geneigt, um mit den seitlichen Seitenwände 62, 63 der Grundschale 16 abzuschließen. Dieser Winkel 65 zwischen umlaufende Rahmen 56 des Kühlkörpers 20 und Haupterstreckungsebene 36 ist in Figur 6 gut erkennbar. So ergibt sich bei der höheren Seitenwand 62 ein Bereich mit vergrößerter Tiefe zwischen Kühlkörper 20 und Grundschale 16, was die Anordnung höherer Bauteile 33 erlaubt, eine verbesserte Konvektion der Kühlluft bewirkt und so insgesamt zu einem kompakt aufgebauten Wechselrichter 1 führt. Zudem zeichnet sich eine Grundschale 16 mit trapezförmigem Längsschnitt V-V durch eine ebene Dichtungskontur ohne Höhensprünge aus. Somit kann eine kostengünstige Aufsteckdichtung - im Gegensatz zu einem aufwendigen Schaumdichtungsprozess - verwendet werden. Insgesamt wird die Konstruktion vereinfacht und ist daher kostengünstiger herstellbar.

Dabei ist die Leiterplatte 32 mit ihrer Bauteilseite 66 in Richtung Boden 64 der Grundschale 16 und anschließend an die höhere Seitenwand 62 der Grundschale 16 angeordnet. Dadurch ergibt sich ein ausreichend großes Raumvolumen, auch zur Platzierung höherer Bauteile 33. Zudem haben gerade höhere Bauteile 33 aufgrund des größeren Volumens auch oft eine größere Wärmeabgabe und eine Anordnung im Randbereich bewirkt eine bessere Wärmeabgabe. Insgesamt hat dies positive Auswirkungen auf die Kühlung des Wechselrichters 1, gerade wenn der Wechselrichter 1 an der Wand montiert ist und diese höhere Seitenwand 62 oben angeordnet ist. Die wärmeren Bauteile 33 sind so über den kühleren, wodurch die Wärmegabe an die Umgebung verbessert wird. Zudem sind durch die Anordnung der Leiterplatte 32 mit ihrer Bauteilseite 66 in Richtung Boden 64 der Grundschale 16 die DC-Eingänge 5 und AC-Ausgänge 11 vom Boden 64 der Grundschale 16 beabstandet angeordnet, was den Zugang zu den DC-Eingängen 5 und AC-Ausgängen 11 erleichtert. Dies wiederum birgt Vorteile für die Inbetriebnahme bzw. Wartbarkeit des Wechselrichters 1 bei einem trotzdem kompakten Aufbau.

Der Anschlussbereich 19 ist anschließend an die niedrige Seitenwand 63 der Grundschale 16 ausgebildet, wodurch DC-Eingang 5 bzw. AC-Ausgang 11 verbessert zugänglich sind. Die Seitenwand 63 in diesem Bereich erlaubt aufgrund ihrer geringeren Höhe bei Inbetriebnahme und Wartungsarbeiten einfachen Zugang zu den Anschlussklemmen 29, 30. Wie aus Figur 2 erkennbar ist, weist der Kühlkörper 20 im Anschlussbereich 19 eine Öffnung 67 auf, die einen vorteilhaften Zugang zu den Anschlussklemmen 29, 30 von DC-Eingang 5 und AC-Ausgang 11 für Inbetriebnahme und Service erlaubt. Die Abschottung der zweiten, inneren Gehäusekammer 38 gegenüber der Außenluft während des Betriebs des Wechselrichters 1 wird durch eine Abdeckung 18 für den Anschlussbereich 19 gewährleistet.

Da die Leiterplatte 32 mit der der Bauteilseite 66 gegenüberliegen Seite am Kühlkörper 20 angeordnet ist, wird die Leiterplatte 32 und damit auch deren elektrische Bauteile 33 vorteilhaft gekühlt. Zudem wird Aufwand für Service und Reparatur vor Ort vereinfacht, da Leiterplatte 32 und Kühlkörper 20 gemeinsam als Austauschelement verfügbar sind. Zusätzlich verbessern Luftleitelemente 68 innerhalb des Gehäuses 14 die Kühlung des Wechselrichters 1. Der Kühlluftstrom wird mithilfe der Luftleitelemente 68 gezielt durch das Gehäuse 14 geführt, um die Kühlung der Wärme abgebenden Bauteile 33 besonders effektiv zu gestalten. Diese Luftleitelemente 68 sind Großteiles am Kühlkörper 20 angeordnet, aber auch an bzw. aus anderen Wechselrichterteilen, wie beispielsweise der Abdeckung 18 des Anschlussbereichs 19, gebildet.

Wie in Fig. 5 bzw. der Explosionszeichnung in Fig. 6 erkennbar, umschließen die Schirmbleche 69, 70, 71 die einzelnen Baugruppen 31 einschließlich des zugehörigen Teils der Leiterplatte 32 käfigförmig und bilden einen Faradayschen Käfig. Dazu werden die seitlichen Schirmbleche 69 über den Bauteilen 33 durch ein weiteres parallel zur Leiterplatte 32 angeordnetes Schirmblech 70 verbunden. Eine besonders effektive Abschirmung der elektromagnetischen Wellen wird so erreicht, die das Einhalten vorgegebener EMV-Grenzwerte erlaubt.

Bei dem dargestellten Ausführungsbeispiel bildet der Kühlkörper 20 auf der der Bauteilseite 66 abgewandten Seite der Leiterplatte 32 das Schirmblech 71. Dies vereinfacht den Aufbau der elektromagnetischen Abschirmung, da der elektrisch leitfähige Kühlkörper 20 die Aufgabe der Schirmung neben der Kühlung übernimmt. Der Kühlkörper 20 kann beispielsweise ein Aluminium-Druckguss-Kühlkörper 20 sein, der neben einer sehr guten Wärmeleitfähigkeit auch eine ausgezeichnete elektrische Leitfähigkeit aufweist. Ein zusätzliches Schirmblech 71 parallel zur Leiterplatte 32 wird eingespart, was den kompakten Aufbau des Wechselrichters 1 begünstigt.

Für die elektromagnetische Abschirmung sind die Baugruppen 31 für DC-DC-Wandler 8, Zwischenkreis 9 und DC-AC-Wandler 10 zusätzlich gegenüber den EMV-Filtern 40, 41 mit zugehörigen DC-Eingang 5 bzw. AC-Ausgang 11 mit Schirmblechen 72, 73 abgeschirmt. Dazu sind seitliche Schirmbleche 72 zwischen Leiterplatte 32 und bauteilseitig abdeckendem Schirmblech 70 angeordnet. Die Lücke zwischen Kühlkörper 20 und Leiterplatte 32 wird mit weiteren Schirmblechen 73 geschlossen. Diese werden kühlkörperseitig auf, vom Kühlkörper 20 gebildete, Dorne 74 gepresst und leiterplattenseitig durch Öffnungen in der Leiterplatte 32 mit den seitlichen Schirmblechen 72 der EMV-Filter 40, 41 Baugruppen 31 verbunden. Diese Verbindung kann mittels einer Steckverbindung mit auf die Leiterplatte 32 gelöteten Federn 75 erfolgen, aber auch eine direkte Verbindung mit den seitlichen Schirmblechen 72 der Baugruppen 31 ist vorstellbar. Bei speziell gestalteten Federn 75 auf einer Seite der Leiterplatte 32 und Öffnungen in der Leiterplatte 32, ist mit ein und derselben Feder 75 eine Befestigung eines EMV-Filters 40, 41 auf beiden Seiten der Leiterplatte 32 möglich. Mit der Abschirmung der EMV-Filter 40, 41 von anderen Baugruppen 31 wird ein Aufschaukeln bzw. Verstärken der Abstrahlungen vermieden. So werden selbst bei kleiner dimensionierten EMV-Filtern 40, 41 erlaubte Grenzwerte eingehalten.

Wie aus Fig. 3 ersichtlich, ist nahe dem DC-Eingang 5 eine Kommunikationseinheit 13 direkt auf der Leiterplatte 32 angeordnet. Informationen von den vorgeschalteten Komponenten des Energiesystems, Energielieferanten wie beispielsweise Batterien oder Solarmodulen 2, können so eingeholt und die Betriebsweise des Wechselrichters 1 aufgrund von aktuellen Daten und Messwerten angepasst werden. Natürlich ist auch eine nicht nähere dargestellte Kommunikationseinheit im Bereich des AC-Ausgangs 11 vorstellbar, um Daten des Wechselrichters 1 weiterzugeben oder um mit eventuell vorhandenen Smart-Metern zu kommunizieren.

Im dargestellten Beispiel eines Photovoltaikwechselrichters 1 nach Fig. 1 ist die Kommunikationseinheit 13 zur Kommunikation mit der Modulelektronik 3 an den Solarmodulen 2 ausgebildet. Informationen auf Modulebene sind dem Wechselrichter 1 daher zugänglich und werden von der Steuereinheit 12 zur Steuerung des Wechselrichters 1 genutzt. Außerdem ist ein modulseitig angeordnetes Sicherheitselement, eine sogenannte Rapid-Shutdown-Box 4, vom Wechselrichter 1 steuerbar, um im Fehlerfall die Energiezufuhr direkt bei den Solarmodulen 2 abschalten zu können.

Denkbar ist, dass sowohl DC-AC-Wandler 10 als auch DC-DC-Wandler 8 für einen bidirektionalen Energiefluss ausgebildet sind. Energie kann daher über den AC-Ausgang 11 an den oder die Verbraucher abgegeben werden. Es kann aber auch Energie über den AC-Ausgang 11 aufgenommen werden, um vorhandene Energiespeicher, wie beispielsweise Batterien, aufzuladen. Abhängig vom jeweiligen Energiespeicher kann dessen Anschluss an den DC-Eingängen 5 aber auch am Zwischenkreis 9 erfolgen.

## Patentansprüche

1. Wechselrichter (1) zur Umwandlung einer Gleichspannung (U_{DC}) in eine Wechselspannung (U_{AC}), insbesondere Photovoltaikwechselrichter für hohe Leistungsdichten, insbesondere Leistungsdichten von 250 W/dm³ bis 500 W/dm³, mit zumindest einem DC-Eingang (5), einem AC-Ausgang (11), einem Kühlkörper (20), einer Leiterplatte (32), einem DC-Trenner (7), einem DC-DC-Wandler (8), einem Zwischenkreis (9), einem DC-AC-Wandler (10) und einem Gehäuse (14) mit einem Frontdeckel (15) und einer Grundschale (16), **dadurch gekennzeichnet, dass** die elektrischen Bauteile (33) des DC-DC-Wandlers (8), Zwischenkreises (9) und DC-AC-Wandlers (10) in Baugruppen (31) zusammengefasst sind, und zumindest der DC-Trenner (7) sowie die Baugruppen (31) des DC-DC-Wandlers (8), Zwischenkreises (9) und DC-AC-Wandlers (10) direkt auf der Leiterplatte (32) U-förmig korrespondierend mit der Energieflussrichtung (34) vom DC-Eingang (5) zum AC-Ausgang (11) angeordnet sind, und dass die Leiterplatte (32) mit der Bauteilseite (66) in Richtung Boden (65) der Grundschale (16) des Gehäuses (14) weisend und mit der der Bauteilseite (66) gegenüberliegenden Seite am Kühlkörper (20) angeordnet ist.

2. Wechselrichter (1) nach Anspruch 1, **dadurch gekennzeichnet, dass** die Leiterplatte (32) gegenüber dem Boden (65) der Grundschale (16) geneigt, vorzugsweise um einen Winkel (65) von maximal 15°, angeordnet ist.

3. Wechselrichter (1) nach Anspruch 1 oder 2, **dadurch gekennzeichnet, dass** eine Steuereinheit (12) vorgesehen ist, welche Steuereinheit (12) zentral auf der Leiterplatte (32) angeordnet ist.

4. Wechselrichter (1) nach einem der Ansprüche 1 bis 3, **dadurch gekennzeichnet, dass** zumindest ein EMV-Filter (40, 41), insbesondere ein DC-Eingangs-EMV-Filter (40) und/oder ein AC-Ausgangs-EMV-Filter (41), vorgesehen ist, welches zumindest eine EMV-Filter (40, 41) direkt auf der Leiterplatte (32) angeordnet ist.

5. Wechselrichter (1) nach einem der Ansprüche 1 bis 4, **dadurch gekennzeichnet, dass** der DC-DC-Wandler (8) und der DC-AC-Wandler (10) für Schaltfrequenzen über 30 kHz, insbesondere Schaltfrequenzen größer gleich 100kHz, ausgebildet sind.

6. Wechselrichter (1) nach einem der Ansprüche 1 bis 5, **dadurch gekennzeichnet, dass** im Frontdeckel (15) eine Ausnehmung (43) für ein Betätigungselement (17) des DC-Trenners (7) und ein Lufteinlass (44) angeordnet sind, und dass eine Betätigungswelle (59) des DC-Trenners (7), vorzugsweise durch Öffnungen (60) an Leiterplatte (32) und Kühlkörper (20) zum Frontdeckel (15) durchgeführt ist.

7. Wechselrichter (1) nach einem der Ansprüche 1 bis 6, **dadurch gekennzeichnet, dass** an der Gehäuseschmalseite (49, 50 oder 51), insbesondere an allen Gehäuseschmalseiten (49, 50, 51), zwischen Frontdeckel (15) und Grundschale (16), insbesondere schlitzförmige, Öffnungen (48, 52) für den Luftauslass vorgesehen sind.

8. Wechselrichter (1) nach einem der Ansprüche 1 bis 7, **dadurch gekennzeichnet, dass** der Kühlkörper (20) zumindest bereichsweise an die Seitenwände (57, 62, 63) der Grundschale (16) des Gehäuses (14) anschließt und der Kühlkörper (20) ein Versteifungsmittel für das Gehäuse (14) bildet.

9. Wechselrichter (1) nach einem der Ansprüche 1 bis 8, **dadurch gekennzeichnet, dass** der Kühlkörper (20) das Gehäuse (14) in zumindest zwei Gehäusekammern (37, 38) unterteilt, wobei zwischen Kühlkörper (20) und Grundschale (16) vorzugsweise eine Dichtung (58) angeordnet ist.

10. Wechselrichter (1) nach einem der Ansprüche 1 bis 9, **dadurch gekennzeichnet, dass** der Längsschnitt (V-V) der Grundschale (16) im Wesentlichen trapezförmig ausgebildet ist, wobei die beiden Seitenwände (62, 63) der Grundschale (16) parallel zueinander sind und eine Seitenwand (63) niedriger als die andere Seitenwand (62) ausgebildet ist.

11. Wechselrichter (1) nach Anspruch 10, **dadurch gekennzeichnet, dass** ein Anschlussbereich (19) zum Anschließen von DC-Quellen an den DC-Eingang (5) und zum Anschließen einer Last oder dgl. an den AC-Ausgang (11) anschließend an die niedrige Seitenwand (63) der Grundschale (16) angeordnet ist.

12. Wechselrichter (1) nach einem der Ansprüche 1 bis 11, **dadurch gekennzeichnet, dass** Schirmbleche (69, 70, 71) zum käfigförmigen Umschließen der Leiterplatte (32) einschließlich der Baugruppen (31) vorgesehen sind, und vorzugsweise der Kühlkörper (20) bereichsweise einen Teil der Schirmbleche (71) bildet.

13. Wechselrichter (1) nach Anspruch 12, **dadurch gekennzeichnet, dass** einzelne Baugruppen (31), insbesondere EMV-Filter (40, 41), gegenüber anderen Baugruppen (31) mit Schirmblechen (72, 73) abgeschirmt sind.

14. Wechselrichter (1) nach einem der Ansprüche 1 bis 13, **dadurch gekennzeichnet, dass** eine Kommunikationseinheit (13) vorgesehen ist, welche Kommunikationseinheit (13) direkt auf der Leiterplatte (32) angeordnet ist.

15. Wechselrichter (1) nach einem der Ansprüche 1 bis 14, **dadurch gekennzeichnet, dass** der DC-AC-Wandler (10) und/oder der DC-DC-Wandler (8) für einen bidirektionalen Energiefluss ausgebildet ist.

## Claims

1. Inverter (1) for converting a DC voltage (U_{DC}) into an AC voltage (U_{AC}), in particular a photovoltaic inverter for high power densities, in particular power densities of 250 W/dm³ to 500 W/dm³, having at least one DC input (5), an AC output (11), a heat sink (20), a printed circuit board (32), a DC disconnector (7), a DC-DC converter (8), an intermediate circuit (9), a DC-AC converter (10) and a housing (14) with a front cover (15) and a basic shell (16), **characterized in that** the electrical components (33) of the DC-DC converter (8), intermediate circuit (9) and DC-AC converter (10) are combined into subassemblies (31), and at least the DC disconnector (7) and the subassemblies (31) of the DC-DC converter (8), intermediate circuit (9) and DC-AC converter (10) are directly arranged on the printed circuit board (32) in a U-shaped manner corresponding to the energy flow direction (34) from the DC input (5) to the AC output (11), and that the printed circuit board (32) is arranged with the component side (66) facing in the direction of the base (65) of the basic shell (16) of the housing (14) and with the side opposite the component side (66) on the heat sink (20).

2. Inverter (1) according to claim 1, **characterized in that** the printed circuit board (32) is inclined relative to the base (65) of the basic shell (16), preferably arranged by an angle (65) of 15° maximum.

3. Inverter (1) according to claim 1 or 2, **characterized in that** a control unit (12) is provided, which control unit (12) is centrally arranged on the printed circuit board (32).

4. Inverter (1) according to one of claims 1 to 3, **characterized in that** at least one EMV filter (40, 41), in particular a DC input EMV filter (40) and/or an AC output EMV filter (41) is provided, said at least one EMV filter (40, 41) being arranged directly on the printed circuit board (32).

5. Inverter (1) according to one of claims 1 to 4, **characterized in that** the DC-DC converter (8) and the DC-AC converter (10) is designed for switching frequencies above 30 kHz, in particular switching frequencies greater than or equal to 100 kHz.

6. Inverter (1) according to one of claims 1 to 5, **characterized in that** in the front cover (15) a recess (43) for an actuating element (17) of the DC disconnector (7) and an air inlet (44) are arranged, and that an actuating shaft (59) of the DC disconnector (7) is preferably passed through openings (60) on the printed circuit board (32) and the heat sink (20) to the front cover (15).

7. Inverter (1) according to one of claims 1 to 6, **characterized in that** on the narrow housing side (49, 50 or 51), in particular on all narrow housing sides (49, 50 or 51), between front cover (15) and basic shell (16), in particular slit-shaped openings (48, 52) for the air outlet are provided.

8. Inverter (1) according to one of claims 1 to 7, **characterized in that** the heat sink (20) connects at least partially to the sidewalls (57, 62, 63) of the basic shell (16) of the housing (14) and the heat sink (20) forms a stiffening means for the housing (14).

9. Inverter (1) according to one of claims 1 to 8, **characterized in that** the heat sink (20) subdivides the housing (14) into at least two housing chambers (37, 38), preferably a sealing (58) being arranged between the heat sink (20) and the basic shell (16).

10. Inverter (1) according to one of claims 1 to 9, **characterized in that** the longitudinal section (V-V) of the basic shell (16) is designed essentially trapezoidal, the two sidewalls (62, 63) of the basic shell (16) being parallel to one another and one sidewall (63) being designed to be lower than the other sidewall (62).

11. Inverter (1) according to claim 10, **characterized in that** a connection region (19) for connecting DC sources to the DC input (5) and for connecting a load or the like to the AC output (11) is arranged adjacent to the lower sidewall (63) of the basic shell (16).

12. Inverter (1) according to one of claims 1 to 11, **characterized in that** shielding plates (69, 70, 71) are provided for cage-like enclosing the printed circuit board (32) including the subassemblies (31), and preferably the heat sink (20) partially forms part of the shielding plates (71).

13. Inverter (1) according to claim 12, **characterized in that** individual subassemblies (31), in particular EMV filters (40, 41) are shielded off against other subassemblies (31) with shielding plates (72, 73).

14. Inverter (1) according to one of claims 1 to 13, **characterized in that** a communication unit (13) is provided, which communication unit (13) is arranged directly on the printed circuit board (32).

15. Inverter (1) according to one of claims 1 to 14, **characterized in that** the DC-AC converter (10) and/or the DC-DC converter (8) is adapted for a bidirectional energy flow.

## Revendications

1. Onduleur (1) pour la conversion d'une tension continue (U_{DC}) en une tension alternative (U_{AC}), plus particulièrement un onduleur photovoltaïque pour des densités de puissance élevées, plus particulièrement des densités de puissance de 250 W/dm³ à 500 W/dm³, avec au moins une entrée DC (5), une sortie AC (11), un radiateur (20), un circuit imprimé (32), un sectionneur DC (7), un convertisseur DC-DC (8), un circuit intermédiaire (9), un convertisseur DC-AC (10) et un boîtier (14) avec un couvercle frontal (15) et une coque de base (16), **caractérisé en ce que** les composants électriques (33) du convertisseur DC-DC (8), du circuit intermédiaire (9) et du convertisseur DC-AC (10) sont regroupés en sous-ensembles (31) et au moins le sectionneur DC (7) ainsi que les sous-ensembles (31) du convertisseur DC-DC (8), du circuit intermédiaire (9) et du convertisseur DC-AC (10) sont disposés en forme de U directement sur le circuit imprimé (32) de manière correspondante à la direction du flux d'énergie (34) de l'entrée DC (5) vers la sortie AC (11) et **en ce que** le circuit imprimé (32) est disposé avec le côté composants (66) orienté en direction du fond (65) de la coque de base (16) du boîtier (14) et avec le côté opposé au côté composants (66) au niveau du radiateur (20).

2. Onduleur (1) selon la revendication 1, **caractérisé en ce que** le circuit imprimé (32) est incliné par rapport au fond (65) de la coque de base (16), de préférence d'un angle (65) de 15° maximum.

3. Onduleur (1) selon la revendication 1 ou 2, **caractérisé en ce qu'**une unité de commande (12) est prévue, cette unité de commande (12) étant disposée de manière centrale sur le circuit imprimé (32).

4. Onduleur (1) selon l'une des revendications 1 à 3, **caractérisé en ce qu'**au moins un filtre CEM (40, 41), plus particulièrement un filtre CEM d'entrée DC (40) et/ou un filtre CEM de sortie AC (41), est prévu, cet au moins un filtre CEM (40, 41) étant disposé directement sur le circuit imprimé (32).

5. Onduleur (1) selon l'une des revendications 1 à 4, **caractérisé en ce que** le convertisseur DC-DC (8) et le convertisseur DC-AC (10) sont conçus pour des fréquences de commutation supérieures à 30 kHz, plus particulièrement des fréquences de commutation supérieures ou égales à 100 kHz.

6. Onduleur (1) selon l'une des revendications 1 à 5, **caractérisé en ce que**, dans le couvercle frontal (15), sont réalisés un évidement (43) pour un élément d'actionnement (17) du sectionneur DC (7) et une entrée d'air (44) et **en ce qu'**un arbre d'actionnement (59) du sectionneur DC (7) est guidé de préférence à travers des ouvertures (60) sur le circuit imprimé (32) et le radiateur (20) vers le couvercle frontal (15).

7. Onduleur (1) selon l'une des revendications 1 à 6, **caractérisé en ce que**, au niveau du côté étroit du boîtier (49, 50 ou 51), plus particulièrement au niveau de tous les côtés étroits du boîtier (49, 50, 51), entre le couvercle frontal (15) et la coque de base (16), sont prévues des ouvertures (48, 52), plus particulièrement en forme de fentes, pour la sortie de l'air.

8. Onduleur (1) selon l'une des revendications 1 à 7, **caractérisé en ce que** le radiateur (20) se raccorde au moins à certains endroits aux parois latérales (57, 62, 63) de la coque de base (16) du boîtier (14) et le radiateur (20) constitue un moyen de rigidification pour le boîtier (14).

9. Onduleur (1) selon l'une des revendications 1 à 8, **caractérisé en ce que** le radiateur (20) divise le boîtier (14) en au moins deux chambres de boîtier (37, 38), un joint d'étanchéité (58) se trouvant de préférence entre le radiateur (20) et la coque de base (16).

10. Onduleur (1) selon l'une des revendications 1 à 9, **caractérisé en ce que** la coupe longitudinale (V-V) de la coque de base (16) présente globalement une forme trapézoïdale, les deux parois latérales (62, 63) de la coque de base (16) étant parallèles entre elles et une paroi latérale (63) étant disposée plus bas que l'autre paroi latérale (62).

11. Onduleur (1) selon la revendication 10, **caractérisé en ce qu'**une partie de raccordement (19) est prévue pour le raccordement de sources DC à l'entrée DC (5) et pour le raccordement d'une charge ou autre à la sortie AC (11) ensuite à la paroi latérale basse (63) de la coque de base (16).

12. Onduleur (1) selon l'une des revendications 1 à 11, **caractérisé en ce que** des tôles de blindage (69, 70, 71) sont prévues pour entourer sous la forme d'une cage le circuit imprimé (32), y compris les sous-ensembles (31), et de préférence le radiateur (20) constitue, à certains endroits, une partie des tôles de blindage (71).

13. Onduleur (1) selon la revendication 12, **caractérisé en ce que** certains sous-ensembles (31), plus particulièrement le filtre CEM (40, 41), sont blindés par rapport à d'autres sous-ensembles (31) avec des tôles de blindage (72, 73).

14. Onduleur (1) selon l'une des revendications 1 à 13, **caractérisé en ce qu'**une unité de communication (13) est prévue, cette unité de communication (13) étant disposée directement sur le circuit imprimé (32).

15. Onduleur (1) selon l'une des revendications 1 à 14, **caractérisé en ce que** le convertisseur DC-AC (10) et/ou le convertisseur DC-DC (8) est conçu pour un flux d'énergie bidirectionnel.
